Europäisches Patentamt

European Patent Office

Office européen des brevets

(19)

(11) Veröffentlichungsnummer : **0 515 352 A1**

## (12) EUROPÄISCHE PATENTANMELDUNG

(21) Anmeldenummer : 92890119.8

(22) Anmeldetag : 19.05.92

(51) Int. Cl.⁵ : **H01J 37/08**, H01J 37/12, H01J 27/10

(30) Priorität : 24.05.91 AT 1067/91

(43) Veröffentlichungstag der Anmeldung :
25.11.92 Patentblatt 92/48

(84) Benannte Vertragsstaaten :
**AT BE CH DE ES FR GB IT LI NL SE**

(71) Anmelder : **IMS Ionen Mikrofabrikations Systeme Gesellschaft m.b.H.
Schreygasse 3
A-1020 Wien (AT)**

(72) Erfinder : **Chalupka, Alfred, Dr.
Laverangasse 24
A-1130 Wien (AT)**

Erfinder : **Lammer, Gertraud, Dr.
Spargelfeldstrasse 162
A-1220 Wien (AT)**
Erfinder : **Stengl, Gerhard, Dr.
Aussichtsweg 20
A-9241 Wernberg (AT)**
Erfinder : **Wolf, Peter, Dr.
Corneliusgasse 3
A-1060 Wien (AT)**
Erfinder : **Fegerl, Johannes
Laverangasse 24
A-1130 Wien (AT)**

(74) Vertreter : **Casati, Wilhelm, Dipl.-Ing. et al
Patentanwälte Casati, Wilhelm, Dipl.-Ing.
Krause, Ernst, Dipl.-Ing. Itze, Peter, Dipl.-Ing.
Amerlingstrasse 8
A-1061 Wien (AT)**

(54) **Ionenquelle.**

(57)    Die Erfindung betrifft eine Ionenquelle vom Typ Duoplasmatron für die Verwendung in der Ionenprojektionslithographie mit einem Plasmaraum, an den eine Elektrodenanordnung anschließt, die drei elektrisch voneinander isolierte, je mit einem zentrisch um eine den Elektroden gemeinsame Achse angeordneten Fenster für den Ionendurchtritt ausgestattete Elektroden aufweist, wobei zur Erzielung einer gegenüber den bekannten Duoplasmatronionenquellen geringeren Energieunschärfe bei etwa genau so großem Durchmesser der virtuellen Quelle vorgeschlagen wird, daß der aus den drei Elektroden (1-3) bestehenden Elektrodenanordnung zunächst eine vierte Elektrode (4) nachgeschaltet ist, die ebenfalls ein zentrisch um die gemeinsame Achse angeordnetes Fenster für den Durchtritt der Ionen aufweist, und daß die vom Plasmaraum (10) her gesehene erste und dritte Elektrode auf zumindest annähernd gleichem Potential liegen, welches im Vergleich zu den ebenfalls zumindest annähernd gleich großen Potentialen der zweiten und letzten Elektrode höher ist, sodaß die aus dem Plasmaraum austretenden Ionen durch die Potentialdifferenz zwischen erster und letzter Elektrode auf ihre Endenergie beschleunigt werden.

FIG.3

EP 0 515 352 A1

Die Erfindung betrifft eine Ionenquelle vom Typ Duoplasmatron für die Verwendung bei ionen-optisch abbildenden Systemen (Ionen-Projektionslithographie, 1 : 1 Maskierte Ionenstrahl-Lithographie, Fokussierte Ionenstrahl-Reparatursysteme) mit einem Plasmaraum, an den eine Elektrodenanordnung anschließt, die drei elektrisch voneinander isolierte Elektroden aufweist, deren jede eine zentrisch um eine gemeinsame Achse angeordnete Apertur (Fenster) zum Durchtritt der aus dem Plasmaraum extrahierten Ionen besitzt.

In Ionenprojektions-Lithographiesystemen werden Strukturen einer Maske mittels Ionenstrahlen auf einem Substrat (Wafer) abgebildet. Die Abbildung geschieht durch eine der Maske nachgeschaltete Ionenoptik, welche aus einer Kombination von ionenoptischen Linsen besteht. Im Falle von elektrostatischen Linsen wird deren Abbildungseigenschaft (Brennweite, Hauptebenen) durch das sogenannte Spannungsverhältnis definiert. Unter dem Spannungsverhältnis R versteht man für Zwei-Elektroden-Linsen (sogenannte Immersionslinsen) mit den Potentialen $V_o$, $V_1$, $R = E_o/E_i$, $E_i$....Eintrittsenergie der Ionen, $E_o$....Austrittsenergie der Ionen, woraus, falls $E_i = -V_o.e$ (e... Elementarladung), $R = V_1/V_o$; für als EINZEL-Linsen geschaltete Drei-Elektrodenlinsen mit den Elektrodenpotentialen $V_o$, $V_1$, $V_o$: $R = (E_i-(V_1-V_o).e/E_i$, e....Elementarladung, woraus, falls $E_i=-V_o.e$, sich ebenfalls ergibt: $R = V_1/V_o$. Durch Anlegen der entsprechenden Potentiale an die Elektroden läßt sich das Spannungsverhältnis auf den für die gewünschte Abbildungseigenschaft geeigneten Wert einstellen - allerdings nur für einen bestimmten Wert der Ionenenergie $E_i$ (bzw. $E_o$). Jede Abweichung der Ionenenergie von dem zugrundegelegten Wert $E_i$ führt zu geänderten Spannungsverhältnissen und damit zu einem anderen Abbildungsmaßstab für denselben Maskenpunkt; das heißt die Qualität der Auflösung nimmt ab. Je größer daher die Energieverschmierung der aus der Ionenquelle austretenden Ionen ist, desto schlechter wird die Auflösung der auf dem Wafer abgebildeten Strukturen. Analoges gilt auch für Magnetlinsen, bei denen ebenfalls die erforderliche Anregung nur auf einen bestimmten Energiewert eingestellt werden kann.

Ein weiterer die Auflösung bestimmender Parameter ist die Größe der sogenannten virtuellen Ionenquelle (d.i. der Ort, von dem die Ionen scheinbar herkommen, also der kleinste Durchmesser jenes Bündels, das erhalten wird, wenn die Ionenbahnen in den feldfreien Raum rückwärts - in Richtung Ionenquelle - somit entgegen der Ionenbewegung geradlinig verlängert werden). Je kleiner diese ist, umso besser ist die Auflösung.

Für Ionenprojektionslithographiesysteme werden daher Ionenquellen benötigt, bei denen der Durchmesser der sogenannten virtuellen Ionenquelle möglichst klein, bevorzugt kleiner oder gleich 10 μm ist. Für Lithographiesysteme haben sich Duoplasmatron-Ionenquellen als sehr günstig erwiesen, weil bei diesen Quellen durch die praktisch laminare Extraktion der Ionen, bei einem Durchmesser der Austrittsöffnung der den Plasmaraum abschließenden Quellenanode von 200 μm, die virtuelle Ionenquelle einen Durchmesser von ca. 10 μm erreicht (AT-PS 386 297).

Aus den oben erwähnten Gründen ist ein weiterer kritischer Punkt bei Ionenprojektions-Lithographiesystemen die Verteilung der Energie der Ionen an der Maske, auf welche die Ionen auftreffen. Da die Spannungsverhältnisse an den Abbildungslinsen nur entsprechend einer einzigen Eintrittsenergie $E_0$ der Ionen eingestellt werden können, verursachen Ionen, deren Eintrittsenergie von der geforderten Energie $E_0$ abweicht, eine Unschärfe der Abbildung der Maskenstruktur auf den Wafer und damit eine Verringerung der Auflösung.

Bisher verwendete Duoplasmatron-Ionenquellen (R. Keller, " A High-Brightness Duoplasmatron Ion Source", in "Ion Implantation: Equipment and Techniques", Springer Series, ed. H.Ryssel, H.Glawischnig) bestehen im wesentlichen aus einem durch eine Anode begrenzten Plasmaraum, in welchem zugeführte Gasteilchen durch Elektroden, die von einem Glühfaden austreten, ionisiert werden, und aus zwei weiteren Elektroden, deren erste (die sogenannte Supressorelektrode) auf einem gegenüber der Anode tieferen Potential liegt, und deren zweite hinter der Anode (die sogenannte Extraktionselektrode) auf einem gegenüber der Supressorelektrode höheren Potential liegt, welches aber immer noch bedeutend niedriger ist als das der Anode. Die Ionen werden somit durch die Potentialdifferenz zwischen Anode und Extraktionselektrode auf ihre Endenergie beschleunigt, welche sich für die aus dem Plasmaraum austretenden Ionen aus der Summe ihrer Anfangsenergie im Plasmaraum und der Beschleunigungsenergie ergibt. Die Supressorelektrode dient zur Unterdrückung der von der Extraktionselektrode kommenden, entgegen dem Ionenstrom laufenden, Sekundärelektronen.

Bedingt durch die statistische Energieverteilung innerhalb des Plasmas entsprechend der Plasmatemperatur ergibt sich bei den bisher verwendeten Duoplasmatron-Ionenquellen eine sogenannte " intrinsische" Energie-Unschärfe von ca +-5eV gegenüber dem durch die Extraktionsspannung gegebenen Mittelwert.

Ein zusätzlicher Beitrag zur Energie-Unschärfe der auf die Maske auftreffenden Ionen entsteht bei den bisher verwendeten Duoplasmatronquellen durch Ionen, welche erst nach der Anode aus den dort vorhandenen neutralen Gasteilchen durch Stoßionisation gebildet werden. Die meisten davon entstehen im Bereich zwischen Anode und Supressorelektrode wegen des dort herrschenden relativ hohen Gasdrucks und der hohen Ionenstromdichte. Da die so entstandenen Ionen nur mehr einen Teil der Beschleunigungsstrecke durchlaufen, ist ihre Energie zum Teil bedeutend niedriger als die der aus dem Plasmaraum herrührenden Ionen. Insgesamt kann der Beitrag dieser Ionen zur Energie-Unschärfe der auf die Maske auftreffenden Ionen, sowohl hinsichtlich der Differenz zur erwarteten Energie als auch hinsichtlich der Anzahl, um ein Vielfaches den der intrinsischen Energie-Unschärfe übersteigen.

Aufgabe der Erfindung ist es, eine Ionenquelle zu schaffen, die eine gegenüber den bekannten Duoplasmatronquellen geringere Energie-Unschärfe aufweist und dabei einen genau so kleinen Durchmesser der virtuellen Quelle besitzt. Als Lösung schlägt die Erfindung hiefür vor, daß der aus den drei Elektroden bestehenden Elektrodenanordnung zumindest eine vierte Elektrode nachgeschaltet ist, die ebenfalls ein zentrisch um die gemeinsame Achse angeordnetes Fenster für den Durchtritt der Ionen aufweist, und daß die vom Plasmaraum her gesehene erste und dritte Elektrode auf zumindest annähernd gleichem Potential liegen, welches im Vergleich zu den ebenfalls zumindest annähernd gleich großen Potentialen der zweiten und letzten Elektrode höher ist, sodaß die aus dem Plasmaraum austretenden Ionen durch die Potentialdifferenz zwischen erster und letzter Elektrode auf ihre Endenergie beschleunigt werden. Durch die erfindungsgemäß vorgesehene Anordnung einer vierten Quellenelektrode und der angeführten Potentialverteilung an den drei auf die das Plasma begrenzende Anode folgenden Elektroden bilden die ersten drei Elektroden eine Art EINZEL-Linse (nämlich eine verzögernde EINZEL-Linse), welche zunächst die von der Anode kommenden Ionen abbremst. Aufgrund der Potentialverteilung der vier Elektroden wird ein Großteil der Ionen, die eine niedrigere als die Extraktionsenergie besitzen, also der Ionen, die erst durch Stöße im Bereich zwischen den beiden ersten auf den Plasmaraum folgenden Elektroden entstehen, zurückgeworfen, können daher die Quelle nicht verlassen. Die vierte Elektrode wirkt als Blende auch für Ionen mit der vorstehend erwähnten "intrinsischen" Energie-Unschärfe, d.h. durch die Wirkung der vier Elektroden ist es nur mehr einem Bruchteil der Ionen, welche eine von der Eintrittsenergie $E_0$ ($E_0 = e.U_0 = > = U_0[eV]$ für einfach geladene Ionen, von denen hier ausschließlich die Rede ist), verschiedene Energie besitzen, möglich, aus der letzten (vierten) Elektrode auszutreten. Es ergibt sich daher, daß die EINZEL-Linse verhindert, daß durch Stoßionisation hinter der Anode gebildete (niederenergetische) Ionen die Quelle verlassen, und daß die der EINZEL-Linse nachgeschaltete vierte Linse verhindert, daß ein zu hoher Anteil von aus dem Plasma abgezogener, gegen über der eingestellten Eintrittsenergie ($E_0$) in das Abbildungssystem zu geringe Ener gie aufweisenden Ionen, die Quelle verlassen. Durch die Erfindung gelingt es sol cherart, die Energie-Unschärfe gegenüber den bekannten Duoplasmatronionenquellen weiter herabzusetzen, weil die aus dem Plasmaraum austretenden Ionen wieder praktisch auf ihre Anfangs- (thermische) Energie heruntergebremst werden; hingegen Ionen, die durch Stoßionisation außerhalb des Plasmaraumes entstehen und daher geringere Energie besitzen als die aus dem Plasmaraum kommenden, durch dieses Potential zurückgeworfen werden.

Um einen Strom von Sekundärelektronen entgegen der Flugrichtung der Ionen zu unterbinden, kann auch noch zwischen der dritten und letzten Elektrode eine Suppressorelektrode angeordnet sein. Diese erhält dann zweckmäßig ein Potential, das etwa 500 V unter dem der letzten Elektrode liegt.

In weiterer Ausgestaltung der Erfindung kann vorgesehen werden, daß bei gewählten Elektrodenpotentialen die Abstände je zweier benachbarter Elektroden so bemessen sind, daß die Feldstärken zwischen benachbarten Elektroden in Achsnähe größer als 5 Megavolt/Meter sind. Die durch die Abstandsfestsetzung zwischen den benachbarten Elektroden erzielte hohe Feldstärke wird benötigt, um den im Plasma bezüglich ihrer Energie und Richtung statistisch verteilten Ionen gleich nach ihrem Verlassen des Plasmas eine (fast) einheitliche Energie und geordnete Richtungen zu erteilen. Daher werden die Ionen auch beinahe punktförmig am Ende der Anode (ersten Elektrode) fokussiert. Die Feldstärke zwischen zweiter und dritter Elektrode ergibt sich aus der gewünschten EINZELlinsen-Wirkung, und die Feldstärke zwischen dritter und letzter' Elektrode hat eine ähnliche Bedeutung wie die zwischen erster und zweite Elektrode; nämlich die Ionen mit verschiedener Richtung und Energie so zu fokussieren, daß sie scheinbar von einem Punkt, der virtuellen Quelle, herkommen

Die erfindungsgemäß vorgesehene annähernde Gleichheit der Potentiale an der ersten und dritten auf den Plasmaraum folgenden Elektroden kann in Weiterbildung der Erfindung so gewählt werden, daß die dritte Elektrode auf einem Potential liegt, welches im Vergleich zum Potential der ersten Elektrode derart höher ist, daß das Potential im Zentrum des Fensters der dritten Elektrode gleich dem Potential oder nur geringfügig niedriger (bis ca. 10 % ) als das Potential der ersten Elektrode ist. Ist das Potential in der Mitte des Fensters der dritten Elektrode exakt gleich dem Potential, das an die erste Elektrode gelegt ist, dann werden alle Ionen, die langsamer sind als die im Plasmaraum entstandenen Ionen, von de dritten Elektrode zurückgeworfen. Für das Potential der dritten Elektrode bedeutet das, daß es etwas höher sein muß als das Potential der ersten Elektrode, da ja das Potential zur Achse zu abnimmt. Um das geforderte Potential an der Achse zu erhalten, müßte das Potential an der dritten Elektrode - je nach Elektrodenausbildung - um etwa 10 % höher sein als das an die erste Elektrode gelegte Potential. Der Gesamtionenstrom wird dann allerdings sehr niedrig, weil auch ein relativ großer Teil der aus dem Plasmaraum kommenden Ionen zurückgeworfen oder so abgelenkt wird, daß die Ionen gegen die vierte Elektrode stoßen. Wird jedoch, wie dies ebenfalls gemäß der Erfindung vorgesehen ist, das Potential im Zentrum des Fensters der dritten Elektrode geringfügig kleiner als das Potential an der ersten Elektrode zugelassen, wird ein etwas höherer Ionenstrom nach der vierten Elektrode erreicht. Hiezu genügt es, an die erste und dritte Elektrode genau gleiche Potentiale zu legen, soferne das Fenster der dritten Elektrode nicht zu groß ist.

Zweckmäßig ist es, wenn in Weiterbildung der Erfindung das Fenster der dritten Elektrode größer oder gleich ist dem Fenster in der vierten Elektrode und das kleinste Fenster sich in der den Plasmaraum abschließenden (ersten) Elektrode befindet. Die dritte Elektrode hat aufgrund ihres Potentials abbremsende Wirkung; diese ist umso stärker, je kleiner das Fenster ist, da damit das Potential in Umgebung der Achse wächst. Wenn die abbremsende Wirkung zu stark ist, kehren die Ionen um oder sie werden so stark abgelenkt, daß sie an die Elektrode stoßen. Es wird daher das Fenster der dritten Elektrode nicht kleiner ausgeführt als jenes in der vierten Elektrode. Der Querschnitt des ersten Fensters begrenzt die Zahl der aus dem Plasmaraum austretenden Ionen. Optimal ist der Querschnitt dann, wenn alle durch dieses Fenster hindurchtretenden Ionen auch noch aus der vierten Elektrode austreten; alle anderen treffen auf Elektroden und tragen zu deren Abnützung bei. Auch der Winkel, unter dem die Ionen nach der vierten Elektrode austreten, soll eine vorgegebene Größe nicht überschreiten, da diejenigen Ionen, die mit zu großem Winkel austreten, von den im Ionenprojektionssystem folgenden Blenden aufgehalten werden. Es hat sich gezeigt, daß die Forderungen nach ausreichendem Ionenstrom erfüllbar sind, wenn das Fenster in der ersten Elektrode den kleinsten Querschnitt besitzt. Zweckmäßig wird daher in besonderer Ausgestaltung der Erfindung die dritte Elektrode mit dem Fenster größten Durchgangsquerschnittes ausgeführt.

Aus Fertigungsgründen ist es von Vorteil, wenn die vier Elektroden von planparallelen Plättchen gebildet sind. Hiebei können die Fenster in den drei Elektroden, die der den Plasmaraum abschließenden Elektrode folgen, gleich groß sein.

Eine weitere Ausgestaltung der Erfindung sieht vor, daß die erste und dritte Elektrode an exakt gleiches Potential gelegt sind und daß die zweite Elektrode an exakt gleiches Potential wie die vierte Elektrode gelegt ist. Diese Ausführungsform stellt insoferne eine Vereinfachung hinsichtlich des Betriebsaufwandes dar, als nur ein Netzgerät benötigt wird.

Schaltungstechnisch einfache Ausführungen ergeben sich, wenn die erste auf den Plasmaraum folgende Elektrode an Erdpotential und die vierte Elektrode an negativem Potential liegt oder wenn - wie dies ebenfalls vorgesehen sein kann, die erste Elektrode, die auf den Plasmaraum folgt, an positives Potential und die vierte Elektrode der Elektrodenanordnung an Erdpotential gelegt ist.

Die Erfindung wird nachstehend anhand der Zeichnung näher erläutert. Es zeigen,

Fig. 1 schematisch die Ionenenergieverteilung bei einer bestimmten Plasmatemperatur T,

Fig. 2, ebenfalls schematisch, die Ionenenergieverteilung hinter der Extraktionselektrode bei herkömmlichen Ionenquellen,

Fig. 3 einen axialen Teil-Längsschnitt eines Ausführungsbeispiels für eine Elektrodenanordnung mit vier Elektroden für eine erfindungsgemäße Ionenquelle,

Fig. 4 die Elektrodenanordnung gemäß Fig. 3, wobei lediglich eine Hälfte der als Rotationskörper ausgebildeten Elektroden wiedergegeben ist, jedoch mit Beispielen für die Potentiale an den Elektroden,

Fig. 5 die in einer Elektrodenanordnung gemäß Fig. 3 bzw. 4 sich ergebenden Bahnen von 1eV-Ionen, wobei zur Darstellung der Maßverhältnisse, der Zeichnung ein Raster unterlegt ist,

Fig. 6 die virtuelle Ionenquelle einer Anordnung gemäß Fig. 3 oder 4, die sich durch Rückwärtsverlängerung der Endbahnen von 1eV-Ionen ergibt,

Fig. 7 eine gegenüber der Ausführungsform der Fig. 3 bis 5 vereinfachte Elektrodenanordnung, wobei die Potentiallinien zwischen den Elektroden eingetragen sind, die ebenfalls als Rotationskörper ausgebildet sind,

Fig. 8 Rückwärtsverlängerung der Ionenendbahnen zur Anordnung gemäß Fig. 7, wobei die Startenergie der Ionen zu 1eV angenommen und der Darstellung eine Anodenspannung $U_0$ von 3 kV zugrundegelegt ist, und

Fig. 9 schematisch die Energieverteilung der Ionen hinter der vierten Elektrode einer Anordnung gemäß Fig. 7.

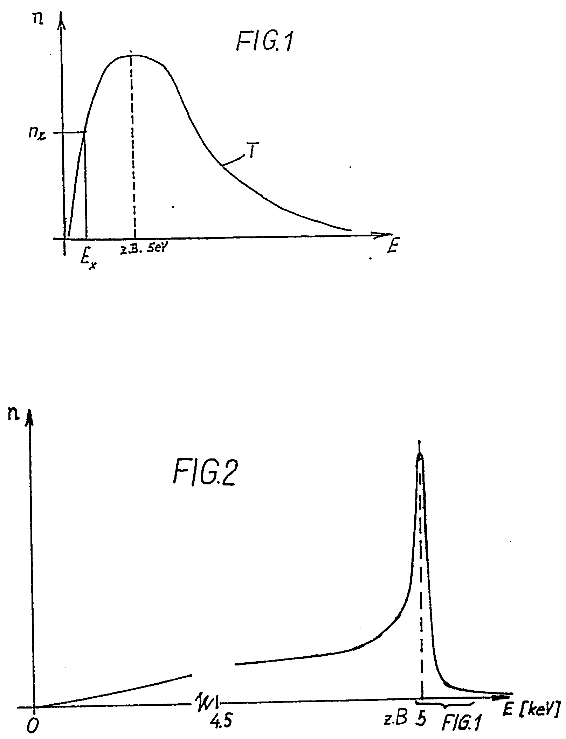

Aus Fig. 1 ist die der Plasmatemperatur entsprechende Energieverteilung ersichtlich, wobei zu einer bestimmten Energie $E_x$ jeweils die Anzahl $n_x$ der Ionen, welche die Energie $E_x$ besitzen, ersichtlich ist. In bekannten Duoplasmatron-Ionenquellen kommt nach Extraktion der Ionen durch die Elektrodenanordnung, die an den Plasmaraum anschließt, noch ein bedeutender Anteil an Ionen mit gegenüber der Extraktionsenergie niedrigerer Energie hinzu, welche von Teilchen herrühren, die im Bereich zwischen Anodenplättchen und Extraktionselektrode durch Stöße ionisiert wurden. Dies veranschaulicht Fig. 2.

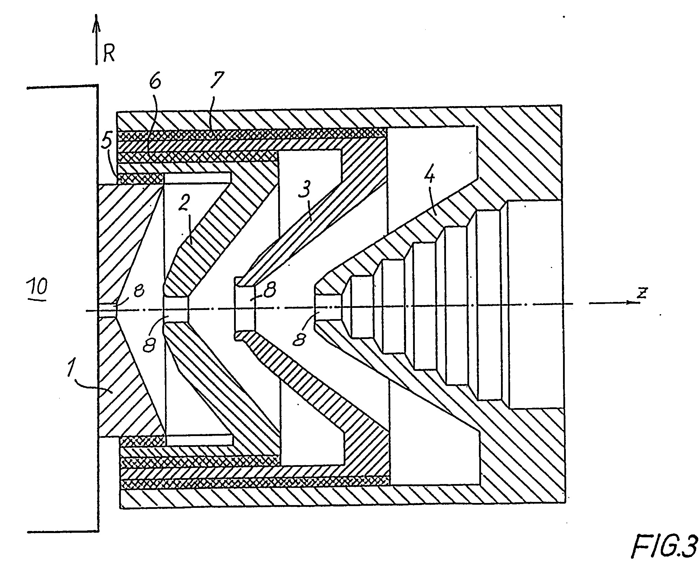

In Fig. 3 bezeichnet 1 die das Plasma 10 austrittsseitig begrenzende Anode. Dieser Anode 1 sind drei weitere Elektroden 2, 3 und 4 nachgeschaltet, deren jede - wie auch die Anode 1 - ein zentrales Fenster für den Durchtritt von Ionen aufweist. Bei den üblichen Ionenquellen, bei welchen die Elektrode 4 fehlt, bildet die mit 2 bezeichnete Elektrode den auf (z.B.) $\dot{\phi}$ V liegenden Suppressor und die mit 3 bezeichnete Elektrode den Extraktor, der auf einer gegenüber der Anodenspannung (z.B. 5,5 kV) geringeren Spannung (z.B. 1,5 kV) gelegt ist. Aufgrund der Potentialverteilung an den Elektroden 1, 2, 3 der erfindungsgemäffen Ionenquelle von $+U_0$ (Elektrode 1), $\dot{\phi}$ (Elektrode 2) und $+U_0$ (Elektrode 3) bilden diese eine verzögernde EINZEL-Linse, der gemäß der Erfindung eine weitere Elektrode 4 nachgeschaltet ist. Diese Elektrode 4 liegt an $\dot{\phi}$ V. Aufgrund der Elektrodenanordnung, die in Fig. 3 in einem z/R Koordinatensystem eingetragen ist, und der vorerwähnten Potentialverteilung von $+U_0$, $\dot{\phi}$V, $+U_0$ und $\dot{\phi}$V wird ein Großteil der Ionen, die eine niedrigere als die Extraktionsenergie besitzen, das sind jene Ionen, die erst durch Stöße im Bereich zwischen den Elektroden 1 und 2 durch Stoßionisation entstehen, zurückgeworfen. Die Elektrode 4 wirkt dabei als Blende auch für Ionen mit "intrisischer" Unschärfe. Die EINZEL-Linse, gebildet von den Elektroden 1, 2, 3 verhindert, daß durch Stoßionisation hinter der Anode (Elektrode 1) gebildete Ionen von niederer Energie die Elektrodenanordnung verlassen, und die Elektrode 4 hindert, daß ein zu hoher Anteil von aus dem Plasma abgesaugter, gegenüber der eingestellten Eintrittsenergie $E_0$ in das Abbildungssystem zu hohe Energie aufweisende Ionen die Elektrodenanordnung verlassen und in das der Elektrodenanordnung nachgeordnete Abbildungssystem eintreten.

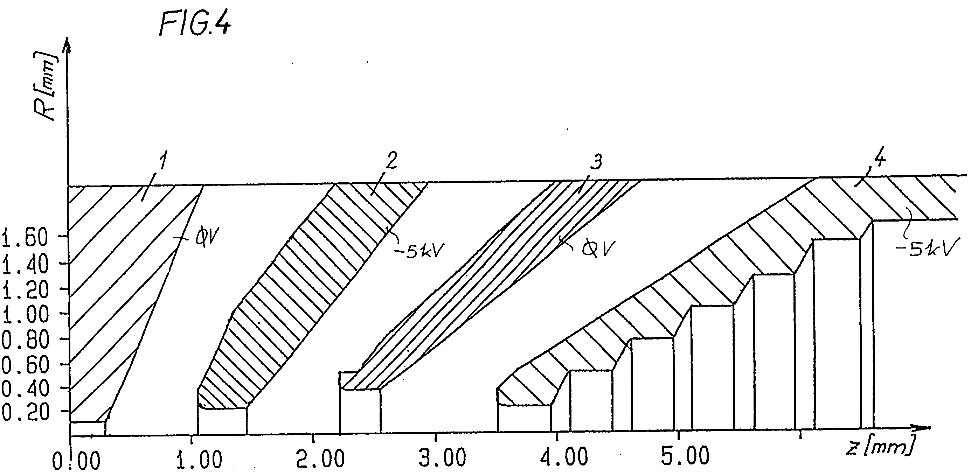

Die Elektroden sind voneinander durch Ringe 5, 6, 7 aus isolierendem Material getrennt. Die Abmessungen der Elektroden 1, 2, 3, 4 und die Spannungen, die an den einzelnen Elektroden liegen, sind aus Fig. 4 ersichtlich. Auf den Achsen z und R des Koordinatensystems sind die Längs- und Radialerstreckung jeweils in mm eingetragen.

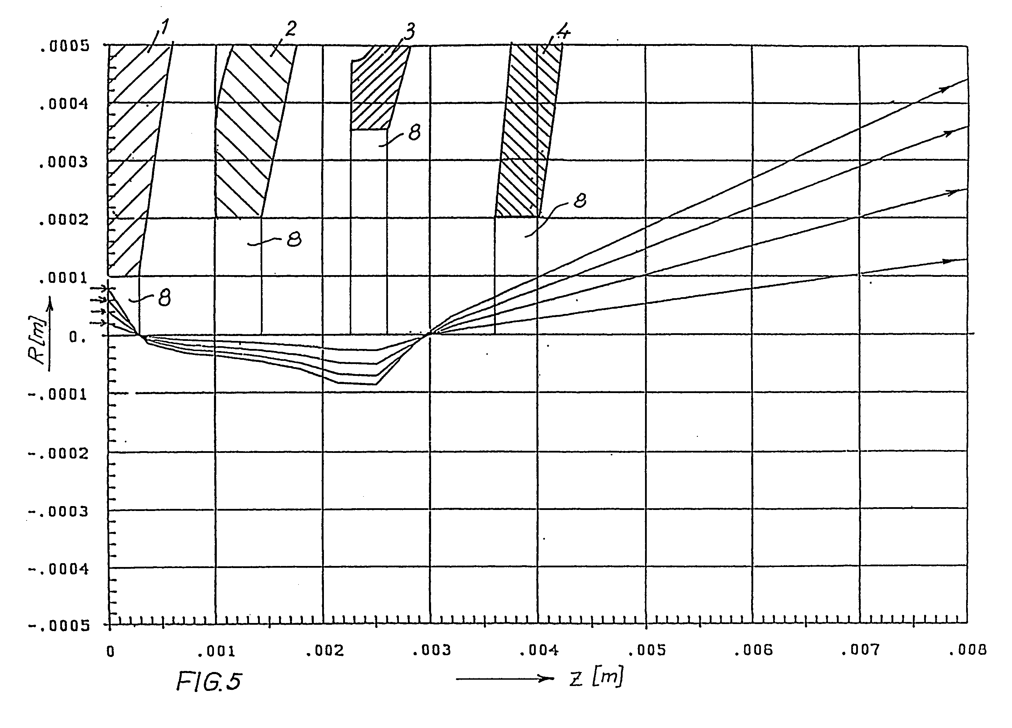

Fig. 5 zeigt ausschnittsweise die Elektroden 1, 2, 3 und 4 der Anordnung gemäß Fig. 3 oder 4 und die rechnerisch ermittelten Ionenflugbahnen für vier Ionen, die in der positiven Hälfte des Fensters 8 der Anode 1 (Elektrode) mit einer Anfangsenergie von 1eV parallel zur z-Achse bei z = 0 eintreten.

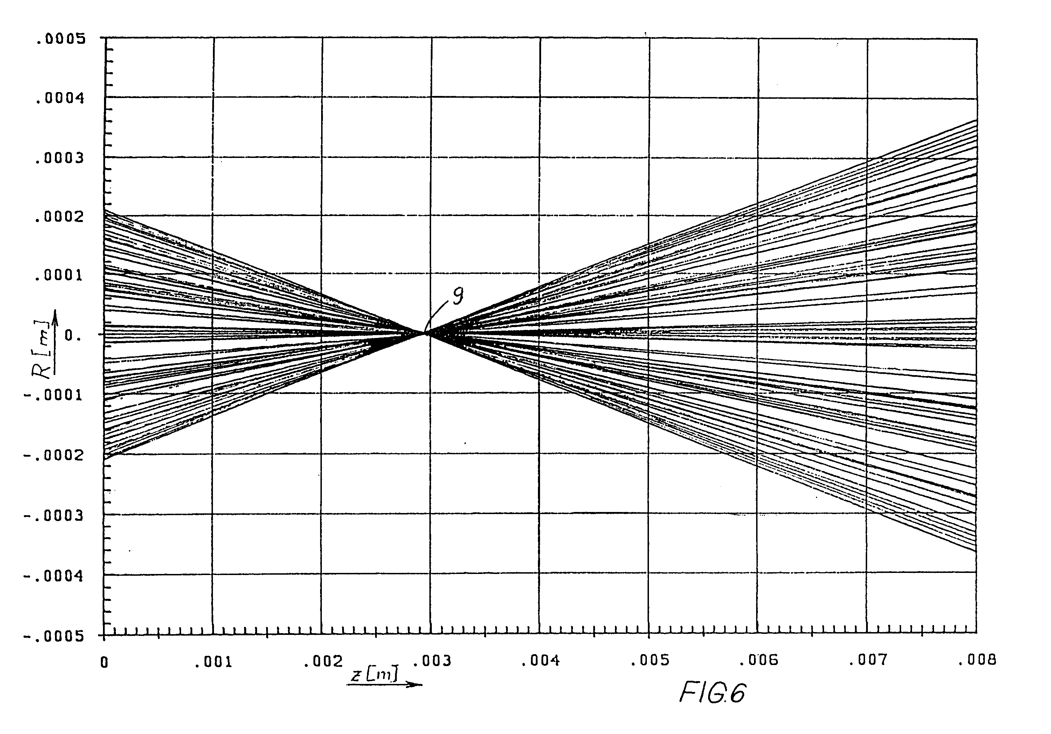

Für Fig. 6 wurden die Bahnen von 49 Ionen durch die Anordnung der Fig. 3 (oder 4) bis zum feldfreien Raum hinter der Elektrode 4 berechnet, und deren geradlinige Ausläufer rückwärts verlängert, wodurch man die Lage und Größe der virtuellen Quelle 9 erhält. Dabei wurden folgende Startbedingungen angenommen:
- die Ionen treten an der Stelle z = 0 mit vorgegebener Anfangsenergie aus dem Plasmaraum 10 der Ionenquelle in das Fenster 8 der Elektrode 1 (Anode) (ebene Plasmabegrenzung angenommen) über;
- die Verteilung der Startpunkte über den Radius des Fensters 8 ist zufällig, genauso wie die Verteilung der Startwinkel, jedoch sind diese mit +10 und -10° zur z-Achse begrenzt;
- die Coulomb-Wechselwirkungen zwischen den Ionen auf den einzelnen Ionenbahnen wurden (aus rechentechnischen Gründen) nicht berücksichtigt.

Aus der nachstehenden Tabelle 1 ist die Größe der virtuellen Quelle und die Energieselektion einer Elektrodenanordnung gemäß Fig. 4 (6) ersichtlich.

## Tabelle 1

| Start-Z (z=0..Plasmagrenze) | Startenergie | Zahl der gestarteten Ioen ($n_0$) | Zahl der durchgelassenen Ionen (n) hinter Elektrode 4 | $n/n_0$ | ~Durchmesser der virt. Quelle |
|---|---|---|---|---|---|
| 0 mm | 1 eV | 49 | 38 | 0,78 | ~ 7 $\mu$m |
| 0 mm | 5 eV | 49 | 23 | 0,47 | ~ 7 $\mu$m |
| 0,2 mm | 1 eV | 49 | 20 | 0,41 | ~ 7 $\mu$m |
| 0,4 mm | 1 eV | 49 | 0 | 0 | |

Die erst bei z = 0,2 bzw. 0,4 mm startenden Ionen sind durch Stoßionisation aus Neutralglas entstanden. Erwünscht ist, daß hinter der 4. Elektrode, somit am Ausgang der Ionenquelle, keine Ionen vorhanden sind, die erst bei z > 0, somit durch Stoßionisation, gebildet wurden. Von den bei z = 0,2 mm startenden Ionen sind am Ausgang aus der Ionenquelle nur mehr 41 % vorhanden, von den bei z = 0,4 startenden Ionen sind am Ausgang aus der Ionenquelle keine mehr vorhanden, d.h. diese Ionen wurden in der von den Elektroden 1, 2, 3 und 4 gebildeten Elektrodenstrecke "gefangen".

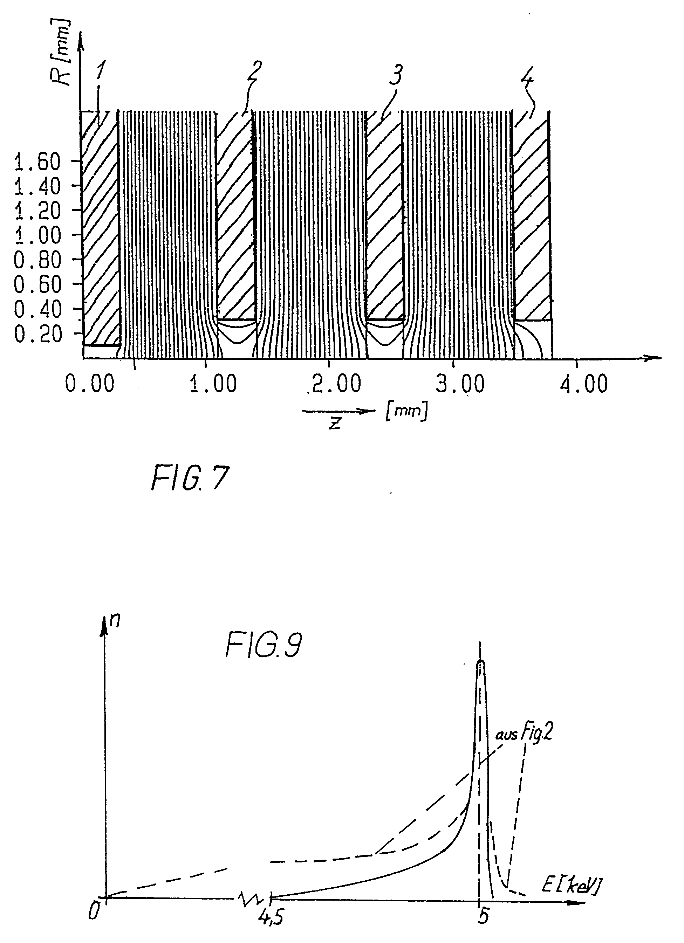

In der Herstellung kann eine Elektrodenanordnung, wie sie in den Fig. 4, 5 und 6 dargestellt ist, bedingt durch die unterschiedlichen Lochdurchmesser, beim Zentrieren Schwierigkeiten verursachen, wozu noch die komplizierte Form der Mantelflächen kommt. Es ist daher anzustreben, Elektroden zu verwenden, die durch ebene Flächen begrenzt werden, da diese leichter und billiger in der Herstellung und auch einfacher zu zentrieren sind. Eine derartige Ausführungsform ist in Fig. 7 schematisch dargestellt, ist funktionsfähig und liefert die gewünschten Resultate. Die Elektroden 1, 2, 3 und 4 sind als planparallele Plättchen ausgebildet. Die Fenster in den Elektroden 2, 3 und 4 weisen gleiche Radien auf. Die Anode (Elektrode 1) und die Elektrode 3 liegen an + $U_0$ und die Elektroden 2 und 4 liegen an Null. Aus Fig. 7 sind auch die Potentiallinien zu ersehen. Die untenstehende Tabelle 2 zeigt analog zur Tabelle 1, jedoch für eine Elektrodenanordnung gemäß Fig. 7 die Größe der virtuellen Quelle und die Energieselektion.

## Tabelle 2

| $U_0$ | Start-Z | Start-energie | Zahl der gestarteten Ionen ($n_0$) | Zahl der durchgelassenen Ionen (n) | $n/n_0$ | Durch-messer der virt. Quelle |
|---|---|---|---|---|---|---|
| 5 kV | 0 mm | 1 eV | 49 | 23 | 0,47 | ~ 10 $\mu$m |
| 5 kV | 0 mm | 5 eV | 49 | 14 | 0,29 | |
| 5 kV | 0 mm | 10 eV | 49 | 14 | 0,29 | |
| 3 kV | 0 mm | 1 eV | 49 | 20 | 0,41 | ~ 10 $\mu$m |
| 3 kV | 0 mm | 5 eV | 49 | 14 | 0,29 | |
| 3 kV | 0 mm | 10 eV | 49 | 9 | 0,19 | |
| 3 kV | 0,2 mm | 0,1 eV | 49 | 27 | 0,55 | |

Aus den Werten von $n/n_0$ bei Start -Z = 0 mm sieht man, daß in dieser Ausführungsform der Gesamtstrom auf weniger als die Hälfte der aus dem Plasma austretenden Ionen reduziert wird. Dies stellt kein Problem dar, solange das Plasma genügend Ionen zur Verfügung stellt. Man erkennt jedoch auch einerseits die Energieselektion innerhalb der "intrinsischen" Energieunschärfe (Startenergien 1 bis 10eV bei Start -Z = 0), anderseits die Selektion für die hinter der Anode gebildeten Ionen. Die Energie der bei Z = 0,2 mm startenden Ionen beträgt ca. 0,97x$U_0$ keV (gegenüber der "Soll-Energie" von $U_0$KeV).

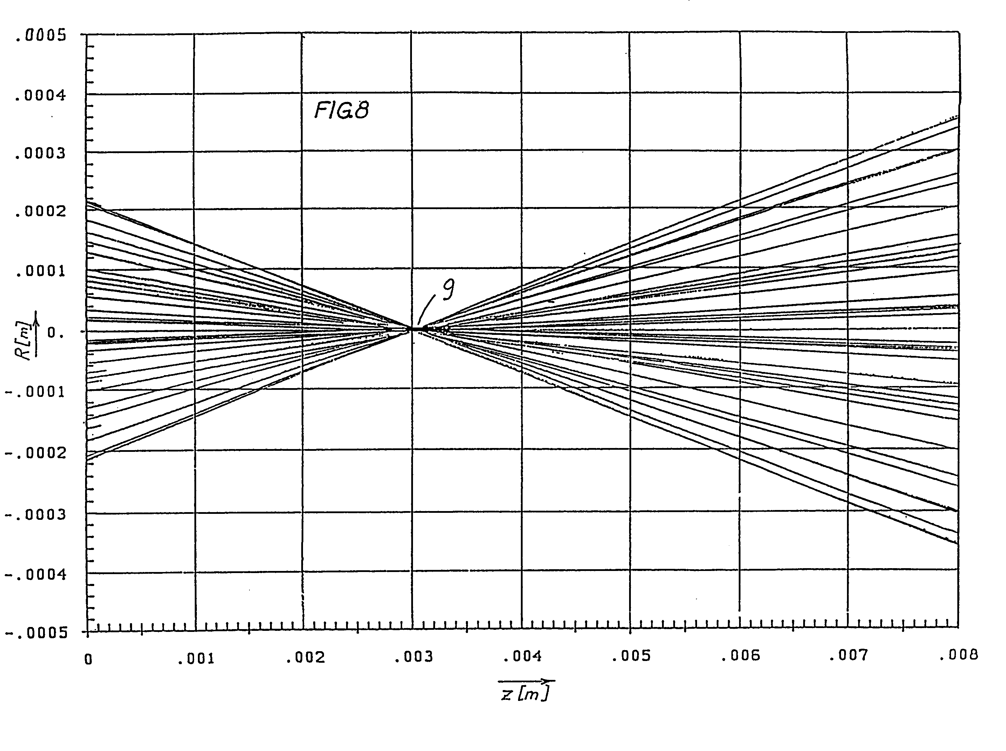

Fig. 8 veranschaulicht die Lage und Größe der virtuellen Quelle 9, analog Fig. 6, jedoch für die Elektrodenanordnung gemäß Fig. 7. Das Potential $U_0$ an den Elektroden 1 und 3 ist zu 3 kV angenommen, das Potential der Elektroden 2 und 4 ist 0 V. Die Startenergie der Ionen beträgt 1 eV.

Fig. 9 veranschaulicht die durch die erfindungsgemäße Anordnung der Fig. 7 erreichte verbesserte Energie-Selektion der in das Linsensystem einer Ionenprojektionslithographie-Anlage eintretenden Ionen.

**Patentansprüche**

1. Ionenquelle vom Typ Duoplasmatron für die Verwendung in ionen-optisch abbildenden Systemen (Ionenprojektions-Lithographie, 1 : 1 maskierte Ionenstrahl-Lithographie, fokussierte Ionenstrahl-Reparatursysteme) mit einem Plasmaraum, an den eine Elektrodenanordnung anschließt, die drei elektrisch voneinander isolierte, je mit einem zentrisch um eine den Elektroden gemeinsame Achse angeordneten Fenster für den Ionendurchtritt ausgestattete Elektroden aufweist, dadurch gekennzeichnet, daß der aus den drei Elektroden (1, 2, 3) bestehenden Elektrodenanordnung zunächst eine vierte Elektrode (4) nachgeschaltet ist, die ebenfalls ein zentrisch um die gemeinsame Achse angeordnetes Fenster für den Durchtritt der Ionen aufweist, und daß die vom Plasmaraum her gesehene erste und dritte Elektrode (1, 3) auf zumindest annähernd gleichem Potential liegen, welches im Vergleich zu den ebenfalls zumindest annähernd gleich großen Potentialen der zweiten und letzten Elektrode (2, 4) höher ist, sodaß die aus dem Plasmaraum (10) austretenden Ionen durch die Potentialdifferenz zwischen erster und letzter Elektrode (1, 4) auf ihre Endenergie beschleunigt werden.

2. Ionenquelle nach Anspruch 1, dadurch gekennzeichnet, daß bei gewählten Elektrodenpotentialen die Abstände je zweier benachbarter Elektroden so bemessen sind, daß die Feldstärken zwischen benachbarten Elektroden in Achsnähe größer als 5 Megavolt/Meter sind.

3. Ionenquelle nach einem der Ansprüche 1 und 2, dadurch gekennzeichnet, daß die dritte Elektrode (3) auf einem Potential liegt, welches im Vergleich zum Potential der ersten Elektrode (1) derart höher ist, daß das Potential im Zentrum des Fensters (8) der dritten Elektrode (3) gleich dem Potential oder nur geringfügig kleiner (niedriger) als das Potential der ersten Elektrode (1) ist.

4. Ionenquelle nach einem der Ansprüche 1 bis 3, dadurch gekennnzeichnet, daß das Fenster (8) der dritten Elektrode (3) größer oder gleich ist dem Fenster (8) in der vierten Elektrode (4) und das kleinste Fenster sich in der den Plasmaraum abschließenden (ersten) Elektrode befindet.

5. Ionenquelle nach einem der Ansprüche 1 bis 3, dadurch gekennzeichnet, daß die dritte Elektrode (3) das Fenster (8) mit dem größten Durchgangsquerschnitt aufweist.

6. Ionenquelle nach Anspruch 1 bis 4, dadurch gekennzeichnet, daß die vier Elektroden (1, 2, 3, 4) von planparallelen Plättchen gebildet sind (Fig. 7).

7. Ionenquelle nach Anspruch 6, dadurch gekennzeichnet, daß die Fenster (8) in den drei Elektroden (2, 3, 4), die der den Plasmaraum (10) abschließenden Elektrode (1) folgen, gleich groß sind (Fig. 7)

8. Ionenquelle nach einem der Ansprüche 1, 2, 4 bis 7, dadurch gekennzeichnet, daß die erste und dritte Elektrode (1, 3) an exakt gleiches Potential gelegt sind und daß die zweite Elektrode (2) an exakt gleiches Potential wie die vierte Elektrode (4) gelegt ist.

9. Ionenquelle nach Anspruch 8, dadurch gekennzeichnet, daß die erste auf den Plasmaraum (10) folgende Elektrode (1) an Erdpotential und die vierte Elektrode (4) an negativem Potential liegt.

10. Ionenquelle nach Anspruch 8, dadurch gekennzeichnet, daß die erste Elektrode (1), die auf den Plasmaraum (10) folgt, an positives Potential und die vierte Elektrode (4) der Elektrodenanordnung an Erdpotential gelegt ist

FIG.1

FIG.2

FIG.3

FIG.4

FIG.5

FIG.6

FIG. 7

FIG.9

FIG8

Europäisches
Patentamt

# EUROPÄISCHER RECHERCHENBERICHT

Nummer der Anmeldung

EP    92 89 0119
Seite 1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | JOURNAL OF VACUUM SCIENCE AND TECHNOLOGY: PART B. Bd. 6, Nr. 3, Mai 1988, NEW YORK US Seiten 941 - 948; MUNRO: 'FINITE DIFFERENCE PROGRAMS FOR COMPUTING TOLERANCES FOR ELECTROSTATIC LENSES' * Zusammenfassung * * Seite 941, linke Spalte, Absatz 1 -Absatz 3 * * Seite 945, rechte Spalte, Absatz 3 - Seite 946, rechte Spalte, Absatz 1; Abbildungen 6,7 * *Tabellen 1, 2* | 1,3,4,8 | H01J37/08 H01J37/12 H01J27/10 |
| A | JOURNAL OF VACUUM SCIENCE AND TECHNOLOGY: PART A. Bd. 8, Nr. 5, September 1990, NEW YORK US Seiten 3758 - 3762; SZEP ET AL.: 'IMPROVED AUTOMATED LENS DESIGN FOR LMI SOURCES' * Zusammenfassung * * Seite 3758, linke Spalte, Absatz 1 * * Seite 3759, linke Spalte, Zeile 1 - Zeile 20 * *Tabelle 1* | 1,2 | |
| A | JOURNAL OF VACUUM SCIENCE AND TECHNOLOGY: PART B. Bd. 3, Nr. 1, Januar 1985, NEW YORK US Seiten 41 - 44; KURIHARA: 'A FOCUSED ION BEAM SYSTEM FOR SUBMICRON LITHOGRAPHY' * Seite 41, linke Spalte, Absatz 1 * * Seite 41, rechte Spalte, Absatz 2 - Seite 42, linke Spalte, Zeile 2; Abbildung 1 * | 1 | **RECHERCHIERTE SACHGEBIETE (Int. Cl.5)**<br><br>H01J |
| D,A | EP-A-0 216 750 (IMS IONEN MIKROFABRIKATIONS SYSTEME GMBH) * Zusammenfassung * * Seite 4, Zeile 2 - Zeile 23 * * Seite 6, Zeile 28 - Seite 7, Zeile 31; Abbildung 1 * | 1 | |

Der vorliegende Recherchenbericht wurde für alle Patentansprüche erstellt

| Recherchenort | Abschlußdatum der Recherche | Prüfer |
|---|---|---|
| DEN HAAG | 25 AUGUST 1992 | GREISER N. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
................................................................
& : Mitglied der gleichen Patentfamilie, übereinstimmendes Dokument

EPO FORM 1503 03.82 (P0403)

**Europäisches Patentamt**

# EUROPÄISCHER RECHERCHENBERICHT

Nummer der Anmeldung

EP    92 89 0119
Seite 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| A | WO-A-9 010 303 (VARIAN)<br>* Zusammenfassung *<br>* Seite 8, Zeile 12 - Zeile 23; Abbildungen 1,2 *<br><br>----- | 1 | |
| | | | **RECHERCHIERTE SACHGEBIETE (Int. Cl.5 )** |

Der vorliegende Recherchenbericht wurde für alle Patentansprüche erstellt

| Recherchenort | Abschlußdatum der Recherche | Prüfer |
|---|---|---|
| DEN HAAG | 25 AUGUST 1992 | GREISER N. |